# EUROPÄISCHE PATENTSCHRIFT

(11) **EP 0 966 698 B1**
(45) Veröffentlichungstag und Bekanntmachung des Hinweises auf die Patenterteilung: **05.12.2001**
(21) Anmeldenummer: 98924008.0
(22) Anmeldetag: 13.03.1998
(51) Int. Cl.: G02B 6/42

(54) **OPTISCH-ELEKTRISCHES MODUL**
OPTO-ELECTRIC MODULE
MODULE OPTO-ELECTRIQUE

(30) Priorität: 13.03.1997 DE 19710504
(43) Veröffentlichungstag der Anmeldung: 29.12.1999
(73) Patentinhaber: SIEMENS AKTIENGESELLSCHAFT, 80333 München (DE)
(72) Erfinder: NEUNER, Thomas, D-81479 München (DE); JURZITZA, Dieter, D-76131 Karlsruhe (DE); BRAND, Uwe, D-81829 München (DE); RESCH, Reinhold, D-80687 München (DE); BURGHARDT, Hartmut, D-83607 Holzkirchen (DE)
(86) Internationale Anmeldenummer: DE9800758
(87) Internationale Veröffentlichungsnummer: WO9840776

(56) Entgegenhaltungen:
- EP-A- 0 348 329
- EP-A- 0 596 613
- DE-A- 3 524 430
- US-A- 4 744 626
- FOSTER E M ET AL: "ESD PACKAGING REQUIREMENTS FOR AN OPTO-ELECTRONIC RECEIVER MODULE" IEEE TRANSACTIONS ON COMPONENTS,HYBRIDS,AND MANUFACTURING TECHNOLOGY, Bd. 13, Nr. 4, 1.Dezember 1990, Seiten 787-790, XP000176824

## Beschreibung

Die Erfindung betrifft ein optisch-elektrisches Modul zum Umsetzen von optischen Signalen in elektrische Signale bzw. von elektrischen Signalen in optische Signale wobei das Modul als mit elektrischen Bauelementen bestückten Schaltungsträger eine Leiterplatte aufweist, welche einerseits als elektrische Schnittstelle im Bereich einer ersten Stirnseite eine Mehrzahl von parallel verlaufenden metallischen Steckkontakten für eine Direktsteckung des Moduls in ein zu diesen Steckkontakten komplementäres Verbindungselement einer elektrischen Baugruppe aufweist, und welche andererseits als optische Schnittstelle im Bereich einer zweiten Stirnseite mit einem optischen Element verbunden ist.

Derartige Module werden häufig in Breitband-Kommunikationssystemen, wie zum Beispiel in nach einem asynchronen Transfermodus (ATM) arbeitenden Kommunikationssystemen, verwendet, da innerhalb eines solchen Systems zum Teil Signalumsetzungen von optischen Signalen in elektrische Signale und umgekehrt vorgesehen sind. So erfolgt beispielsweise häufig aufgrund einer geforderten hohen Datendurchsatzrate eine Übertragung von Nachrichtensignalen, in einem ATM-System in Form von Nachrichtenzellen, lediglich innerhalb vorhandener Koppelfelder in elektrischer Form. Nach Durchlauf eines solches Koppelfeldes wird dann beispielsweise eine Mehrzahl von in gleicher Richtung weiterzuleitenden Nachrichtensignalströmen gemultiplext und durch einen elektrisch/optische Wandler in ein optisches Multiplexsignal umgesetzt, welches anschließend zu einer nachfolgenden Systemeinrichtung, z.B. zu einem nachfolgenden Koppelfeld, weitergeleitet wird. In umgekehrter Richtung wird ein aus einer Mehrzahl von Nachrichtensignalströmen gebildetes, einem Koppelfeld zugeführtes optisches Multiplexsignal durch einen optisch/elektrischen Wandler in die einzelnen Nachrichtensignalströme zerlegt und in elektrische Nachrichtensignalströme umgesetzt. Diese Nachrichtensignalströme werden dann über das entsprechende Koppelfeld weitergeleitet.

Es ist nun Aufgabe der vorliegenden Erfindung, einen Weg zu zeigen, wie ein optisch-elektrisches Modul der eingangs genannten Art ausgebildet werden kann, um dieses einerseits kostengünstig zu realisieren und andererseits auch für die Übertragung von hohen Bitraten auszulegen.

Diese Aufgabe wird bei einem Modul der eingangs genannten Art dadurch gelöst,
daß das optische Element in eine von der zweiten Stirnseite aus Senkrecht nach innen velaufende Ausnehmung der Leiterplatte aufgenommen und dort mit seinen elektrischen Anschlüssen an Lötkontakte der Leiterplatte angelötet ist
und daß Bauelementeseite und Rückseite der Leiterplatte jeweils durch ein vorzugsweise metallisches Gehäuseteil zumindest teilweise abgedeckt sind.

Anspruch 1 ist gegen US-A-4 744 626 in der zweiteiligen Form abgegrenzt. Die Erfindung bringt dabei den Vorteil mit sich, daß das optisch-elektrische Modul mit einfachen konstruktiven Mitteln kostengünstig und platzsparend realisiert werden kann. Darüber hinaus ist durch die Steckbarkeit des Moduls eine variable Bestückung und ein einfacher Austausch möglich. Schließlich ist durch die Direktkontaktsteckung ein sehr guter elektrischer hochfrequenter Übergang erreichbar.

Vorteilhafte Ausgestaltungen des optisch-elektrischen Moduls ergeben sich aus den Patentansprüchen 2 bis 6. Auf deren Vorteile wird im Zusammenhang mit der Erläuterung eines Ausführungsbeispiels der Erfindung eingegangen.

Im folgenden wird die vorliegende Erfindung anhand von Zeichnungen beispielsweise näher beschrieben.

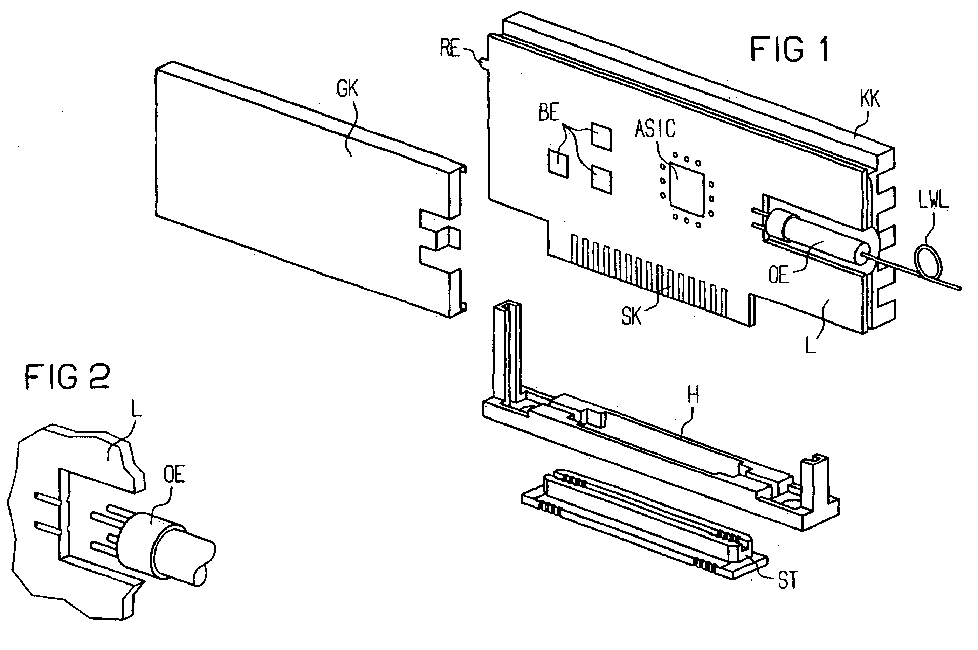

FIG 1 zeigt in perspektivischer Form eine schematische Explosionszeichnung für ein optisch-elektrisches Modul gemäß der vorliegenden Erfindung und FIG 2 zeigt ausschnittweise eine in FIG 1 dargestellte Leiterplatte und ein darin aufzunehmendes optisches Element.

Das in FIG 1 dargestellte optisch-elektrische Modul weist eine als Schaltungsträger dienende Leiterplatte L auf, auf welcher bei dem vorliegenden Ausführungsbeispiel sämtliche für eine Signalumsetzung von optischen Signalen in elektrische Signale und umgekehrt dienenden Bauelemente BE, ASIC vorhanden sind. Die Basis bildet dabei ein kundenspezifischer Baustein ASIC. Dieser kundenspezifische Baustein ist dabei zur Platzeinsparung und zur besseren Wärmeableitung in"Nacktchip"-Technologie, die auch als "Chip-On-Board"-Technologie bezeichnet ist, in die Leiterplatte eingesetzt. Der Baustein ist dabei zusammen mit den Bonddrähten durch eine Epoxi-Abdeckung in Tropfenform ("GlOBETOP") geschützt.

Im Bereich der unteren Stirnseite der Leiterplatte L, und zwar in deren Mittelbereich, ist eine Mehrzahl von senkrecht parallel verlaufenden metallischen Steckkontakten SK als elektrische Schnittstelle des optisch-elektrischen Moduls vorgesehen, welche bei dem vorliegenden Ausführungsbeispiel für eine gute Leitfähigkeit vergoldet sind. Diese Steckkontakte, die beispielsweise zu beiden Seiten der Leiterplatte angeordnet sind, dienen für eine Direktsteckung des optisch-elektrischen Moduls in ein zu diesen Steckkontakten komplementäres Verbindungselement ST einer nicht dargestellten elektrischen Baugruppe. Für eine Aufnahme der Steckkontakte in das als Buchsenleiste ausgebildete Verbindungselement ST springt der diese Steckkontakte aufweisende Teil der Leiterplatte an der Stirnseite hervor. Der zu beiden Seiten der Steckkontakte liegende Teil der Leiterplatte ist dagegen gegenüber den Steckkontakten zurückgesetzt.

Im übrigen ist die Buchsenleiste ST in eine in FIG 1 mit H bezeichneten Halterung eingesetzt, die ihrerseits auf der zuvor erwähnten Baugruppe fixiert ist, beispielsweise durch Schraubverbindungen. Diese Halterung weist an ihren beiden Stirnseiten jeweils eine Führungsschiene auf. Durch die beiden Führungsschienen ist das optisch-elektrische Modul sowohl beim Einstecken in die Buchsenleiste als auch im eingesteckten Zustand geführt. Um ein unbeabsichtigtes Lockern des Moduls zu vermeiden, ist zumindest im Bereich einer der zu den Steckkontakten SK senkrecht verlaufenden Stirnseiten der Leiterplatte ein Rastelement RE vorgesehen, welches in ein dazu komplementäres Rastelement der in Frage kommenden Führungsschiene der Halterung H für eine Lagefixierung des Moduls aufgenommen ist. Das Rastelement RE ist dabei beispielsweise als Rastnase an der genannten Stirnseite der Leiterplatte L (in FIG 1 auf der linken Seite) ausgebildet, welche von einer Vertiefung in der erwähnten Führungsschiene aufnehmbar ist.

Die optische Schnittstelle des optisch-elektrischen Moduls ist durch ein optisches Element OE mit daran angeschlossenem Lichtwellenleiter LWL gebildet. Dieses optische Element, welches je nach der Übertragungsrichtung des Moduls aus einer Laserdiode (Sender) oder aus einer sogenannten PIN-Diode (Empfänger) gebildet ist, ist in eine axial zu dem optischen Element verlaufende, den Abmessungen des optischen Elementes entsprechende Ausnehmung der Leiterplatte L aufgenommen. Nach FIG 1 verläuft diese Ausnehmung von der Mitte der rechten Stirnseite der Leiterplatte L nach innen, und zwar senkrecht zu den Steckkontakten SK.

In FIG 2 ist die Anordnung des optischen Elementes OE in der zuvor genannten Ausnehmung der Leiterplatte L detaillierter dargestellt. Wie in dieser FIGUR angedeutet ist, verfügt das optische Element über eine Mehrzahl von Anschlüssen, beispielsweise vier Anschlüsse bei einer Laserdiode mit Monitordiode und drei Anschlüsse bei einer PIN-Diode. Dieses optische Element ist in der genannten Ausnehmung bis auf einen Luftspalt von lmm an die Stirnfläche der Leiterplatte L geführt und dort mit seinen Anschlüssen an beiden Seiten der Leiterplatte angelötet, und zwar bei einer Laserdiode mit je zwei Anschlüssen pro Leiterplatten-Seite und bei einer PIN-Diode mit zwei Anschlüssen auf der einen Leiterplatten-Seite und dem verbleibenden einen Anschluß auf der anderen Leiterplatten-Seite. Der Luftspalt zwischen dem optischen Element und der Leiterplatte dient im übrigen zur thermischen Entlastung dieses optischen Elementes.

Wie in FIG 1 angedeutet ist, ist auf der Rückseite der Leiterplatte L ein vorzugsweise metallisches Gehäuseteil vorgesehen, durch welches diese Leiterplatte oberhalb der Steckkontakte SK abgedeckt ist. Bei dem vorliegenden Ausführungsbeispiel ist dieses Gehäuseteil zur Wärmeabführung als Kühlkörper KK ausgebildet. Dieser Kühlkörper weist eine ebene Innenfläche zum Aufkleben auf die Rückseite der Leiterplatte L und eine mit Kühlrippen versehene Außenseite auf. Darüber hinaus ist die Leiterplatte mehrlagig mit dicken Kupfer-Innenlagen ausgebildet, um eine günstige Wärmeverteilung innerhalb der Leiterplatte zu erreichen.

Auf der Innenfläche des Kühlkörpers ist unterhalb der für das optische Element OE vorgesehenen Ausnehmung der Leiterplatte L eine den Abmessungen dieser Ausnehmung entsprechende, als Halbzylinder ausgebildete Vertiefung vorgesehen, in welche das optische Element etwa zur Hälfte aufgenommen ist.

Der Kühlkörper ist zu der Leiterplatte L hin an seiner oberhalb der Steckkontakte SK liegenden Kante mit einem über die gesamte Kante verlaufenden Falz versehen. Ein entsprechender Falz ist auch an der gegenüberliegenden Kante des Kühlkörpers angebracht. Durch diese beiden Falze bildet sich zwischen Leiterplatte L und Kühlkörper KK oben und unten je eine Nut aus. Diese Nuten dienen als noch zu erläuternde Rastelemente für ein an der Bauelementeseite der Leiterplatte L anbringbares vorzugsweise metallisches Gehäuseteil GK, welches vorzugsweise als Gehäusekappe ausgebildet ist, um die auf der Leiterplatte vorhandenen Bauelemente mechanisch zu schützen und hochfrequente Störeinflüsse zu vermeiden. Diese Gehäusekappe weist bei dem Ausführungsbeispiel an ihrer zu der Leiterplatte hin gerichteten, parallel zu der zuvor erwähnten oberen Nut verlaufenden Kante eine nach unten zeigende, senkrecht über die gesamte Länge abgewinkelte Verlängerung auf. Mit dieser Verlängerung ist die Gehäusekappe GK in diese Nut aufnehmbar.

Die Gehäusekappe GK liegt im Bereich oberhalb der Steckkontakte SK auf der Leiterplatte L an. In den beiden Bereichen neben den Steckkontakten ist dagegen in Richtung Leiterplatte zumindest je eine Lasche vorgesehen, die über die Leiterplatte in Richtung Kühlkörper hinausragt. In jeder dieser Laschen ist eine nach innen weisende Rastnase vorhanden, welche in die oben bereits erwähnte untere Nut zwischen Leiterplatte L und Kühlkörper KK einrastet. Diese Nut stellt somit ein komplementäres Rastelement für diese Rastnasen dar.

Darüber hinaus weist die Gehäusekappe GK im Bereich des optischen Elementes OE einen von deren Stirnseite zur Oberseite verlaufenden Ausschnitt auf, in welchem eine mehrfach abgewinkelte, im Inneren der Gehäusekappe ausgebildete federnde Lasche vorhandenen ist. Diese Lasche drückt bei eingerasteter Gehäusekappe als Druckfeder gegen das optische Element OE.

Durch das Einlöten des optischen Elementes OE und dessen federnde Fixierung durch die Gehäusekappe GK sind keine zusätzlichen Befestigungsflansche an diesem optischen Element für eine Befestigung erforderlich. Außerdem wird zusammen mit den übrigen vorstehend erläuterten konstruktiven Mitteln erreicht, daß ein optisch-elektrische Element OE keinerlei Schraubverbindungen aufweist und somit kostengünstig endmontiert werden kann. Im übrigen kann durch die platzsparende Aufbauweise eines optisch-elektrischen Moduls auf einer zuvor erwähnten Baugruppe eine Vielzahl derartiger Module untergebracht sein.

Durch das zuvor erläuterte Steckprinzip von Moduln auf Baugruppen ergeben sich weitere Vorteile bezüglich Handhabbarkeit, Service, Reparatur und Herstellkosten der Baugruppen. So kann einerseits ein in eine für ein optisch-elektrisches Modul vorgesehene Buchsenleiste einer Baugruppe eingestecktes Steckmodul mit elektrischen Prüfleitungen dazu benutzt werden, um eine elektrische Prüfung der betreffenden Baugruppe ohne Verwendung eines optisch-elektrischen Moduls durchführen zu können. Dies ist insbesondere in der Testphase einer Baugruppe vorteilhaft.

Außerdem gestattet die Verwendung des Steckprinzips von Moduln auf einer Baugruppe, die tatsächliche Bestückung der Baugruppe mit Moduln an den Nutzungsgrad der Baugruppe anzupassen. Das bedeutet, daß gerade nicht benötigte optischelektrische Module durch kostengünstige Terminierungsmodule ersetzt werden, die in Form und Größe den optisch-elektrische Module entsprechen und den Modulanschluß impedanzmäßig abschließen. Je nach Bedarf können dann Terminierungsmodule durch im Vergleich zu diesen kostenaufwendigere optisch-elektrische Module ersetzt werden.

Abschließend sei noch darauf hingewiesen, daß die vorstehend erläuterten konstruktiven Mittel zum Aufbau eines optisch-elektrischen Moduls auch modifiziert sein können. Dies trifft insbesondere für die oben erwähnten Rastelemente und die dazu komplementären Rastelemente zu.

## Patentansprüche

1. Optisch-elektrisches Modul zum Umsetzen von optischen Signalen in elektrische Signale bzw. von elektrischen Signalen in optische Signale,
- wobei das Modul als mit elektrischen Bauelementen bestückten Schaltungsträger eine Leiterplatte (L) aufweist, welche einerseits als elektrische Schnittstelle im Bereich einer ersten Stirnseite eine Mehrzahl von parallel verlaufenden metallischen Steckkontakten (SK) für eine Direktsteckung des Moduls in ein zu diesen Steckkontakten komplementäres Verbindungselement (ST) einer elektrischen Baugruppe. aufweist,
- und welche andererseits als optische Schnittstelle im Bereich einer zweiten Stirnseite mit einem optischen Element (OE) verbunden ist, **dadurch gekennzeichnet, daß** das optische Element (OE) in eine von der zweiten Stirnseite aus senkrecht nach innen verlaufende Ausnehmung der Leiterplatte (L) aufgenommen und dort mit seinen elektrischen Anschlüssen an Lötkontakte der Leiterplatte (L) angelötet ist und
- **daß** Bauelementeseite und Rückseite der Leiterplatte (L) jeweils durch ein vorzugsweise metallisches Gehäuseteil (GK, KK) zumindest teilweise abgedeckt sind.

2. Optisch-elektrisches Modul nach Anspruch 1,
**dadurch gekennzeichnet,**
**daß** der an der Rückseite der Leiterplatte (L) vorgesehene Gehäuseteil als Kühlkörper (KK) ausgebildet ist.

3. Optisch-elektrisches Modul nach Anspruch 2,
**dadurch gekennzeichnet,**
**daß** der Kühlkörper (KK) mit einer zu der Leiterplatte hin gerichteten ebenen Fläche an der Rückseite der Leiterplatte befestigt vorzugsweise angeklebt ist.

4. Optisch-elektrisches Modul nach einem der Ansprüche 1 bis 3,
**dadurch gekennzeichnet,**
**daß** der an der Bauelementeseite der Leiterplatte (L) vorgesehene Gehäuseteil (GK) als Gehäusekappe ausgebildet ist, welche über Rastelemente mit dem an der Rückseite der Leiterplatte (L) vorgesehenen Gehäuseteil lösbar verbunden ist.

5. Optisch-elektrisches Modul nach einem der Ansprüche 1 bis 4,
**dadurch gekennzeichnet,**
**daß** die Steckkontakte (SK) sowohl an der Bauelementeseite als auch an der Rückseite der Leiterplatte (L) angebracht sind.

## Claims

1. Optoelectrical module for converting optical signals to electrical signals and electrical signals to optical signals,
- in which the module has a printed circuit board (L) as a circuit mount fitted with electrical components, which printed circuit board (L) firstly has, as an electrical interface in the region of a first end face, a number of parallel-running metallic plug contacts (SK) for direct connection of the module to a connecting element (ST), which is complementary to these plug contacts, of an electrical assembly,
- and which, secondly, as an optical interface in the region of a second end face, is connected to an optical element (OE), **characterized in that** the optical element (OE) is held in a recess, which runs inwards at right angles from the second end face, in the printed circuit board (L) and is soldered there by its electrical connections to solder contacts on the printed circuit board (L), and
- **in that** the component face and the rear face of the printed circuit board (L) are each at least partially covered by a preferably metallic housing part (GK, KK).

2. Optoelectrical module according to Claim 1,
**characterized in that**
the housing part which is provided on the rear face of the printed circuit board (L) is in the form of a heat sink (KK).

3. Optoelectrical module according to Claim 2,
**characterized in that**
the heat sink (KK) is attached, preferably bonded, to the rear face of the printed circuit board by a planar surface pointing towards the printed circuit board.

4. Optoelectrical module according to one of Claims 1 to 3,
**characterized in that**
the housing part (GK) which is provided on the component face of the printed circuit board (L) is in the form of a housing cap, which is detachably connected via latching elements to the housing part which is provided on the rear face of the printed circuit board (L).

5. Optoelectrical module according to one of Claims 1 to 4,
**characterized in that**
the plug contacts (SK) are fitted both to the component face and to the rear face of the printed circuit board (L) .

## Revendications

1. Module opto-électrique pour la conversion de signaux optiques en signaux électriques ou de signaux électriques en signaux optiques,
- le module en tant que support de circuit équipé de composants électriques comportant une carte de circuits imprimés (L) qui comporte d'une part en tant qu'interface électrique dans la zone d'un premier côté frontal une multiplicité de contacts à fiches métalliques (SK) s'étendant parallèlement pour un enfichage direct du module dans un élément de liaison (ST), complémentaire de ces contacts à fiches, d'un élément électrique et qui est reliée d'autre part en tant qu'interface optique dans la zone d'un deuxième côté frontal à un élément optique (OE),
- **caractérisé par le fait que** l'élément optique (OE) est logé dans un évidement, s'étendant à partir du deuxième côté frontal perpendiculairement vers l'intérieur, de la carte de circuits imprimés (L) et y est brasé par ses bornes électriques sur des contacts à braser de la carte de circuits imprimés (L) et
- le côté à composants et le verso de la carte de circuits imprimés (L) sont recouverts respecivement au moins partiellement par une partie de boîtier (GK, KK) de préférence métallique.

2. Module opto-électrique selon la revendication 1,
**caractérisé par le fait que** la partie de boîtier prévue sur le verso de la carte de circuits imprimés (L) est conçue comme un radiateur de refroidissement (KK).

3. Module opto-électrique selon la revendication 2,
**caractérisé par le fait que** le radiateur de refroidissement (KK) est fixé, collé de préférence, avec une surface plane dirigée vers la carte de circuits imprimés contre le verso de la carte de circuits imprimés.

4. Module opto-électrique selon l'une des revendications 1 à 3,
**caractérisé par le fait que** la partie de boîtier (GK) prévue sur le côté à composants de la carte de circuits imprimés (L) est conçue comme un cache de boîtier qui est assemblé, amovible, par l'intermédiaire d'éléments d'arrêt à la partie de boîtier prévue sur le verso de la carte de circuits imprimés (L).

5. Module opto-électrique selon l'une des revendications 1 à 4,
**caractérisé par le fait que** les contacts à fiches (SK) sont placés aussi bien sur le côté à composants de la carte de circuits imprimés (L) que sur le verso de celle-ci.
